# FASCICULE DE BREVET EUROPEEN

(11) **EP 3 673 518 B1**
(45) Date de publication et mention de la délivrance du brevet: **09.06.2021**
(21) Numéro de dépôt: 18827177.9
(22) Date de dépôt: 19.11.2018
(51) Int. Cl.: H01L 31/18

(54) **PROCÉDÉ AMÉLIORÉ DE DOPAGE DE CELLULE SOLAIRE**
VERBESSERTES VERFAHREN ZUR DOTIERUNG VON SOLARZELLEN
IMPROVED METHOD FOR SOLAR CELL DOPING

(30) Priorité: 22.11.2017 FR 1761069
(43) Date de publication de la demande: 01.07.2020
(73) Titulaire: Commissariat à l'énergie atomique et aux énergies alternatives, 75015 Paris (FR)
(72) Inventeur: CABAL, Raphaël, 73000 Chambery (FR); LANTERNE, Adeline, 24460 Saint-Front-d'Alemps (FR)
(74) Mandataire: Brevalex
(86) Numéro de dépôt international: PCT/FR2018/052900
(87) Numéro de publication internationale: WO 2019/102118

(56) Documents cités:
- US-A1- 2014 352 769
- US-B2- 8 598 021

## Description

### DOMAINE TECHNIQUE ET ART ANTÉRIEUR

La présente invention a trait au domaine des cellules photovoltaïques encore appelées cellules solaires et de leur fabrication.

De telles cellules sont généralement formées à partir d'un substrat semi-conducteur comportant des couches dopées ayant des types de conductivité opposés. Par exemple une couche supérieure s'étendant du côté d'une face, appelée « face avant », est composée d'un semi-conducteur dopé par exemple selon un dopage de type P. Dans ce cas, on peut prévoir une couche inférieure dopée N au niveau d'une autre face du substrat opposée à la face avant et appelée « face arrière ».

Le dopage des couches supérieures et inférieures peut être réalisé par implantation. Même en utilisant une technique d'implantation classique à l'aide d'un faisceau directionnel, la réalisation de régions dopées par implantation peut engendrer la formation de zones dopées non-désirées au niveau des bords ou du pourtour de la face opposée du substrat.

Dans le cas de l'implantation classique, ce dopage non désiré des bords peut être dû à une mauvaise focalisation du faisceau ou à un problème de divergence du faisceau, voire à un mauvais positionnement du substrat par rapport au faisceau.

Un tel dopage non désiré des bords du substrat par une espèce dopante normalement dédiée au dopage de la face avant, peut être à l'origine de courants de fuite au niveau de la cellule solaire une fois celle-ci achevée.

Pour éviter cela, le document US 8 598 021 B2 propose de prévoir sous le substrat à implanter, un support muni de régions spécifiques dopées dépassant des bords du substrat. Le type de dopage de ces régions spécifiques est choisi de manière adéquate, en prévoyant en particulier un dopage de type opposé à celui prévu pour la face avant. Le faisceau d'implantation impactant ces régions spécifiques dopées permet par pulvérisation d'implanter des ions issus de ces régions au niveau des bords du substrat. Le dopage par implantation « directe » du faisceau et celui par pulvérisation sont alors censés se compenser.

Toutefois, avec une telle méthode il est difficile de contrôler précisément la quantité de dopants issus de la pulvérisation afin de pouvoir réaliser une compensation précise. Une telle méthode est donc difficilement reproductible et applicable à l'échelle industrielle.

Le document US 2014/352769 A1 décrit la formation d'une jonction p/n le long des bords latéraux du substrat de la cellule solaire. La jonction p/n est obtenue par implantation des bords latéraux du substrat avec des dopants de chaque type ou par un procédé de diffusion de ces dopants dans le substrat.

La présente invention vise à résoudre au moins partiellement les problèmes précités.

### EXPOSÉ DE L'INVENTION

Un but de la présente invention est de pouvoir réaliser un dopage par implantation de la face avant d'un substrat de cellule solaire, tout en évitant de créer des jonctions parasites ou des zones dopées non-désirées à l'origine de courants de fuite.

Pour cela, selon un aspect, la présente invention prévoit de former sur des bords latéraux du substrat, une couche barrière qui est configurée de manière à limiter une pénétration d'espèce dopante au niveau des bords latéraux du substrat lors de l'implantation de la face avant.

Plus particulièrement, cette couche barrière est une couche contenant des dopants ou au moins un dopant que l'on fait diffuser au niveau des bords du substrat afin de pouvoir compenser ou surpasser le dopage réalisé lors de l'implantation de la face avant.

On effectue ainsi un dopage « d'un premier type » du matériau semi-conducteur, par exemple de type N, opposé à celui dit « d'un deuxième type » réalisé lors de l'implantation de la face avant et qui peut être par exemple un dopage de type P.

Par compenser, on entend que les concentrations en espèces dopantes accepteuses et donneuses dans le matériau semi-conducteur au niveaux des bords latéraux sont proches ou prévues de sorte à obtenir une zone dopée globalement neutre jouxtant les bords du substrat.

Dans du silicium, on peut compenser par exemple un dopage au Phosphore par un dopage au Bore de concentration proche de celle du Bore et inversement. Par « proches » on entend ici que les concentrations respectives diffèrent de moins d'une décade.

Avantageusement, la quantité de dopants du premier type incorporés par le biais de la couche barrière dans le matériau semi-conducteur est prévue de telle sorte que des zones dopées au niveau des bords latéraux du substrat sont globalement dopées selon le premiertype de dopage, en particulier N+ ou N++. Ainsi, le dopage du premier type (par exemple de type N) surpasse celui du deuxième type (par exemple de type P).

Ainsi, selon un mode de réalisation, la présente invention prévoit un procédé de réalisation d'une cellule photovoltaïque comprenant des étapes de:
- formation sur des bords latéraux d'un substrat à base de matériau semi-conducteur, d'une couche barrière contenant des dopants, la couche barrière étant à base d'un matériau diélectrique, les dopants étant adaptés pour réaliser un dopage d'un premier type, en particulier de type N, dudit matériau semi-conducteur,
- implantation de la face avant du substrat au moyen d'une espèce dopante donnée adaptée pour réaliser un dopage d'un deuxième type, en particulier de type P, opposé au premier type de dopage, la couche barrière étant apte à limiter une pénétration de ladite espèce dopante donnée au niveau des bords latéraux du substrat lors de cette implantation,
- recuit thermique de sorte à réaliser une diffusion dans le matériau semi-conducteur desdits dopants contenus dans ladite couche barrière au niveau des bords latéraux du substrat, de sorte à compenser ou surpasser le dopage réalisé lors de l'implantation de la face avant du substrat.

La diffusion des dopants de la couche barrière permet d'éviter de créer des jonctions au niveau des bords latéraux du substrat, de réduire les courants de fuite sur la périphérie de la cellule et d'améliorer ainsi le facteur de forme (FF) de la cellule. Un gain en absolu d'au moins 0,3% peut être obtenu pour ce facteur.

Le fait d'utiliser une couche barrière contenant des dopants pour réaliser un dopage des bords latéraux et d'effectuer ce dopage par diffusion, permet de contrôler précisément le dopage des bords latéraux du substrat. Cela peut permettre également de faire diffuser une quantité importante de dopants et en particulier plus importante que dans un procédé suivant l'art antérieur dans lequel on effectue ce dopage par pulvérisation.

Par exemple, la concentration en dopant peut dépasser 4.10²⁰ at/cm³ dans le cas d'une couche contenant du phosphore et d'un recuit à 1050°C, avec une dose totale de l'ordre de 1.10¹⁶ at/cm².

La couche barrière est à base d'un matériau diélectrique. Une fois le dopage par diffusion réalisé, on peut ainsi conserver cette couche et mettre en œuvre une passivation. La couche barrière peut ainsi permettre à la fois de servir de couche de protection lors de l'implantation de la face avant, de couche de dopage, et de couche de passivation. Son rôle en tant que couche de passivation permet d'améliorer le courant de court-circuit Jcc ainsi que la tension en circuit ouvert Voc de la cellule.

La mise en œuvre d'une telle couche barrière s'applique particulièrement bien à un procédé dans lequel le dopage de la face avant est effectué par implantation ionique par immersion plasma (PIII) cette technique étant multidirectionnelle et ayant tendance à doper le substrat au niveau de toutes les faces dévoilées de ce dernier.

La couche barrière peut être avantageusement formée de sorte à recouvrir des régions périphériques de la face arrière du substrat. On protège ainsi avantageusement les bords latéraux du substrat et le pourtour de la face arrière du substrat. Ainsi, contrairement à une technique par pulvérisation telle que décrite précédemment dans la partie « art antérieur », on peut mettre en œuvre une protection et un dopage de régions de la face arrière.

Selon une possibilité de mise en œuvre du procédé, la couche barrière peut être formée par dépôt localisé tandis qu'un masquage est disposé sur la face arrière du substrat, des régions périphériques de la face arrière n'étant alors pas recouvertes par le masquage.

Avantageusement, le recuit thermique permettant la diffusion des dopants contenus dans la couche barrière est prévu selon une durée et une température adaptés de sorte à réaliser une activation concomitante de dopants de ladite espèce dopante donnée implantés en face avant du substrat. Ainsi, on peut réaliser une diffusion de dopants pour réaliser par exemple un dopage N au niveau des bords latéraux du substrat tout en activant les dopants par exemple de type P utilisés pour doper la face avant.

Le procédé peut comprendre en outre des étapes de :
- dopage d'un premier type au niveau la deuxième face du substrat, puis
- recuit de sorte à réaliser une activation de dopants au niveau la deuxième face et une redistribution desdits dopants du premier type au niveau des bords latéraux du substrat.

Un mode de réalisation particulier prévoit une couche barrière dopée au phosphore en particulier pour réaliser un dopage de type N, tandis que l'espèce dopante donnée implantée en face avant est du Bore afin de réaliser un dopage de type P au niveau de la face avant.

Un mode de réalisation particulier prévoit la mise en œuvre d'une couche barrière à base de nitrure de silicium dopé au phosphore (SiN:P) ou d'oxyde de silicium dopé au phosphore (SiO:P).

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
Les figures 1A-1H servent à illustrer un premier exemple de procédé suivant l'invention pour la mise en œuvre d'une cellule solaire à partir d'un substrat sur le pourtour duquel on forme une couche de protection dopante permettant de compenser un éventuel dopage des bords du substrat lors du dopage de sa face avant ;
La figure 2 sert à illustrer illustre un exemple de profil de concentration en dopants à l'aide d'un dopage provenant d'une couche barrière mise en œuvre sur les bords latéraux d'un substrat ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « avant », « supérieure », « arrière », « inférieure », « latérale », s'appliquent en considérant que la structure est orientée de la façon illustrée sur les figures.

### EXPOSÉ DÉTAILLÉ DE MODES DE RÉALISATION PARTICULIERS

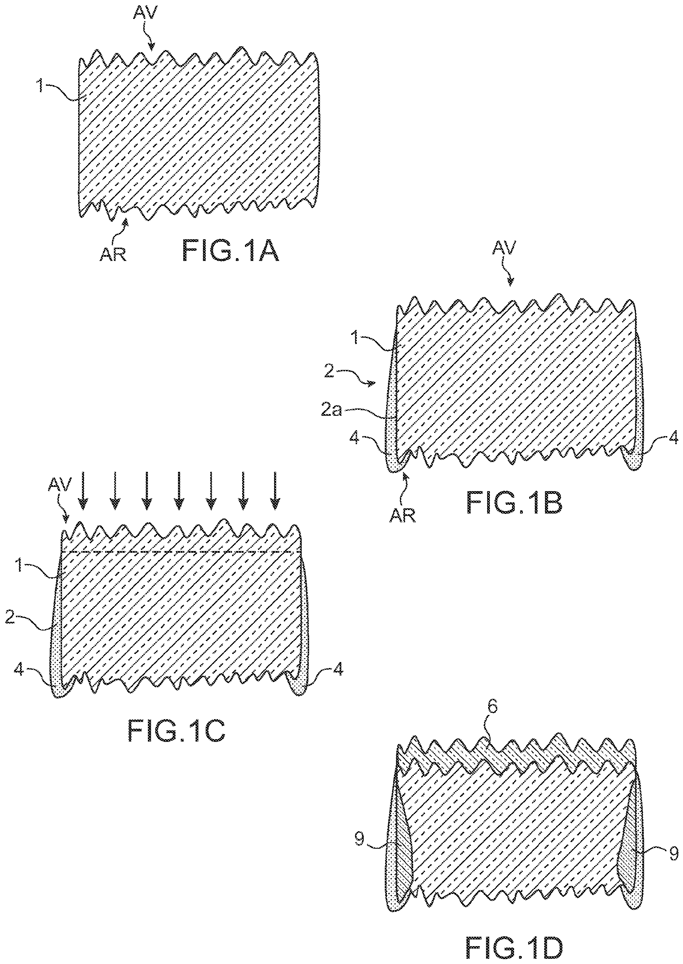

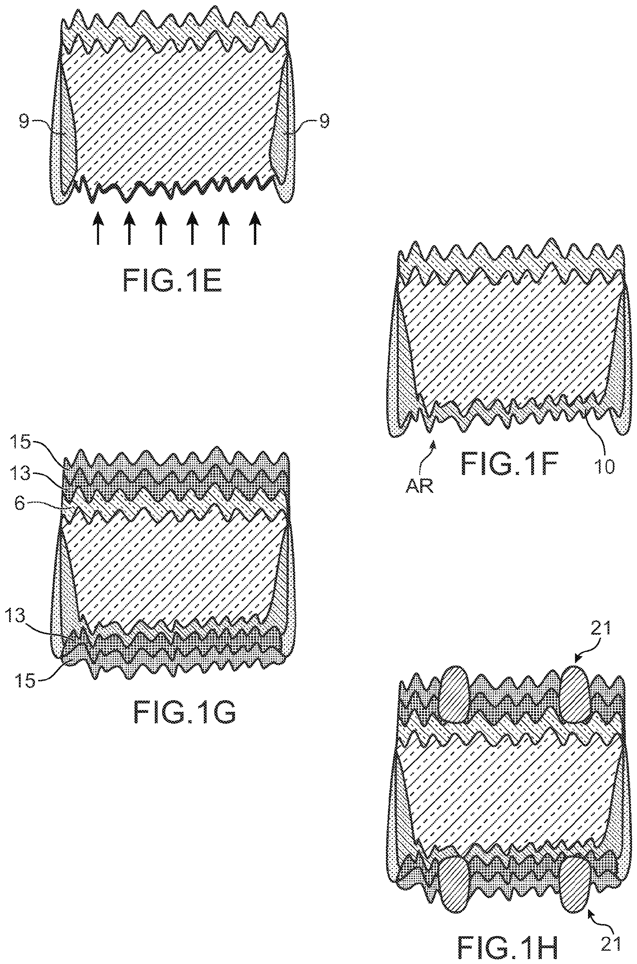

Un exemple de procédé de fabrication d'une cellule photovoltaïque suivant un mode de réalisation de la présente invention va à présent être décrit en liaison avec les figures 1A-1H.

Le matériau de départ de ce procédé peut être un substrat 1 à base de matériau semi-conducteur cristallin tel que par exemple du silicium cristallin. Le substrat 1 est dopé par exemple selon un dopage de type N.

Afin de diminuer la réflectivité de la surface de la cellule et d'augmenter le chemin optique de la lumière dans le dispositif, une texturation d'au moins une face du substrat 1 est avantageusement prévue. Cette opération permet de former en surface un relief, par exemple sous forme de motifs pyramidaux micrométriques. La texturation peut être réalisée par action mécanique ou par attaque chimique, par exemple en plaçant le substrat 1 dans un bain contenant une solution de KOH.

Dans l'exemple illustré sur la figure 1A, une texturation du substrat 1 est mise en œuvre aussi bien au niveau de sa face avant AV que de sa face arrière AR.

Par « face avant » AV on entend dans cet exemple une face du substrat 1 qui est destinée à être directement exposée au soleil, tandis que la « face arrière » AR est celle opposée à la face avant.

On effectue ensuite un dépôt localisé d'une couche 4 de protection encore qualifiée de « couche barrière » au niveau de régions 2a des bords 2 latéraux du substrat, les bords latéraux étant des zones allant de la face avant AV à la face arrière AR du substrat 1.

La couche 4 barrière est prévue notamment pour protéger le substrat 1 lors d'une étape ultérieure de dopage par implantation, en particulier de la face avant AV. pour réaliser un dopage au niveau des bords 2 du substrat 1, en particulier un dopage de type opposé à celui prévu pour la face avant destiné à être réalisé ultérieurement.

Ainsi, la couche 4 barrière est ici adaptée pour réaliser un dopage du même type que celui du substrat 1. La couche 4 barrière contient dans cet exemple une espèce donneuse, par exemple du phosphore, afin de réaliser un dopage de type N. La proportion atomique d'atomes de phosphore est alors typiquement comprise entre 1 et 10 %.

La couche 4 barrière a une épaisseur qui peut être comprise par exemple entre 10 et 200 nm, de préférence entre 20 et 50 nm.

La couche 4 barrière est à base de matériau diélectrique et peut être ainsi adaptée pour réaliser une passivation des bords latéraux du substrat 1. Par exemple, ce matériau diélectrique peut être du nitrure de silicium dopé au phosphore (SiN :P), d'oxyde de silicium dopé au phosphore (SiO :P) ou l'un de leurs dérivés tels qu'un oxynitrure de silicium dopé au phosphore.

De préférence, on réalise la couche barrière 4 par dépôt sous vide, par exemple en utilisant une technique de PECVD (pour « Plasma Enhanced Chemical Vapor Déposition »).

Dans l'exemple de réalisation particulier illustré sur la figure 1B, la couche barrière 4 en plus de recouvrir les bords latéraux, est réalisée également de sorte à recouvrir et protéger des zones périphériques 3a de la face arrière AR du substrat 1.

Pour permettre une telle réalisation localisée de la couche barrière 4, on peut prévoir un masquage (non représenté sur la figure 1B) recouvrant les parties sur lesquelles on ne souhaite pas former cette couche 4, en particulier sur la face avant AV du substrat 1 et sur une région centrale de la face arrière AR, des zones périphériques 3a de la face arrière AR étant dévoilées et non-protégées par ce masquage.

La figure 1C illustre une étape ultérieure de dopage par implantation d'une région 6 du substrat 1 qui s'étend le long de la face avant AV du substrat 1 (figure 1C). On effectue de préférence un dopage de type P, afin de réaliser une région 6 dopée communément appelée « émetteur ». Cette région 6 ici de type P, a ainsi une conductivité opposée à celle du substrat 1 de départ, dans cet exemple initialement dopé N.

Le dopage de la face avant AV est avantageusement effectué par implantation par immersion plasma (PIII pour « Plasma Immersion Ion Implantation »), technique qui utilise un plasma comme source d'espèce dopante. Cette technique de dopage permet de réaliser un dopage à très faible énergie et à coût réduit. L'implantation de type PIII est multidirectionnelle et la couche barrière 4 permet alors de limiter voire d'empêcher un dopage intempestif au niveau des bords 2 latéraux et des zones périphériques 3a de la face arrière AR du substrat 1.

Dans cet exemple de réalisation, le dopage de la face avant AV est typiquement réalisé à l'aide de Bore. Au niveau des bords latéraux de la structure, l'implantation d'ions Bore se fait dans la couche barrière 4 et non dans le silicium du substrat 1, la couche barrière 4 permettant ainsi d'éviter la diffusion du bore dans le silicium.

Ensuite, on procède à un recuit thermique prévu à une température et selon une durée adaptées de sorte à réaliser une activation de dopants de la région 6 dopée située au niveau de la face avant AV. Le recuit est également prévu pour permettre de faire diffuser les dopants contenus dans la couche 4 barrière. Par exemple pour réaliser une diffusion de Phosphore au niveau des bords latéraux et une activation concomitante de Bore au niveau de la face avant AV, le recuit peut être réalisé à une température comprise par exemple entre 800°C et 1100°C, selon une durée qui peut être par exemple comprise entre 1minute et 90minutes.

La figure 1D illustre la structure à l'issue du recuit avec des zones 9 résultant de la diffusion des dopants de la couche barrière 4 et jouxtant cette dernière au niveau des bords latéraux 2 du substrat 1. Le dopage par diffusion permet de définir précisément les zones dopées et de mettre en œuvre un niveau de dopage important. La concentration en dopants peut en particulier dépasser 4.10²⁰ at/cm³ dans le cas d'une couche contenant du phosphore et d'un recuit à 1050°C, avec une dose totale de l'ordre de 1.10¹⁶ at/cm².

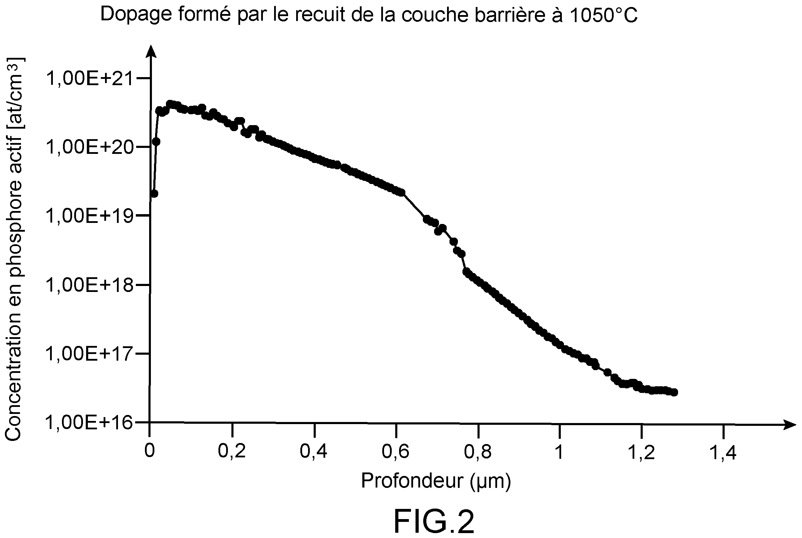

Sur la figure 2, la courbe Ci donne un exemple de profil de concentration en dopants phosphore obtenu après un tel recuit à 1050°C dans de telles conditions de dopage par le biais de la couche barrière.

Les zones 9 formées peuvent être par exemple dopées N+ ou N++.

Ensuite, on met en œuvre un dopage d'une région 10 qui s'étend le long de la face arrière AR du substrat 1 afin de réaliser une région 10 dopée communément appelée de BSF (« Back Surface Field »). On effectue dans cet exemple un dopage de type N, cette région 10 ayant ainsi une conductivité de même type que celle du substrat 1 de départ. Le dopage de la face arrière AR est dans ce cas réalisé typiquement à l'aide de Phosphore. Ce dopage peut être réalisé par implantation (figure 1E). On utilise une implantation ionique classique c'est-à-dire utilisant un faisceau directionnel ou bien une implantation par immersion plasma. On peut également envisager de réaliser un tel dopage par diffusion.

Puis, on effectue au moins un autre recuit thermique prévu selon une température et une durée adaptées pour réaliser une activation de dopants de la région 10 dopée située au niveau de la face arrière AR. Pour réaliser l'activation de dopants phosphore dans le silicium le recuit peut être effectué à une température comprise par exemple entre 780°C et 1100°C de préférence entre 800°C et 900°C, selon une durée qui peut être par exemple comprise entre 1min et 90min.

Selon une possibilité de mise en œuvre du recuit d'activation, on peut effectuer celui-ci sous une atmosphère oxydante afin de former une couche d'oxyde de silicium sur la face avant AV et la face arrière AR du substrat 1. Une telle couche peut servir de couche 13 de passivation.

En variante, pour former cette couche 13 de passivation on peut effectuer une oxydation thermique une fois le recuit d'activation réalisé.

Selon une autre variante, on peut à la fois réaliser le recuit d'activation de dopants sous atmosphère oxydante puis effectuer au moins une oxydation thermique.

On peut ensuite former sur au moins une face du substrat 1 une couche 15 à base d'un matériau, de préférence diélectrique, et d'épaisseur prévus de manière à servir d'anti-reflet. Dans l'exemple de réalisation particulier illustré sur la figure 1G, on dépose une couche anti-reflet 15 en face avant AV et en face arrière AR du substrat 1. La couche antireflet 15, par exemple en SiNx, permet de réduire les pertes optiques liées aux réflexions du rayonnement lumineux et d'optimiser l'absorption du rayonnement lumineux par le substrat 1.

De manière optionnelle, une couche antireflet 15 en SiNx, peut être également utilisée comme couche dédiée à la passivation.

Puis (figure 1H), on forme des électrodes 21 métalliques, en face avant AV et en face arrière AR du substrat. Typiquement, cette étape comporte une métallisation qui peut être réalisée par sérigraphie. Les électrodes 21 peuvent être formées d'une couche d'oxyde conducteur transparent tel que de l'ITO sur laquelle repose une couche métallique par exemple à base d'Ag.

Dans l'exemple de réalisation qui vient d'être décrit la couche barrière 4 peut être conservée à l'issue du procédé. La couche barrière permet ainsi non seulement de compenser les effets du dopage par implantation d'ions bore en face avant mais également de former une passivation des tranches ou bords latéraux du substrat.

Selon une variante de réalisation de l'exemple de procédé qui vient d'être donné, on peut partir d'un substrat de type N, mais prévoir de réaliser l'émetteur en face arrière AR. Dans ce cas-là un procédé semblable à celui décrit précédemment peut être mis en œuvre, seules les régions dopées 6, 10 étant inversées.

Selon une autre variante de réalisation, on peut mettre en œuvre un recuit d'activation de dopants commun pour la face avant et la face arrière. Dans ce cas, on effectue le dopage par implantation de la face avant puis de la face arrière, ou bien le dopage par implantation de la face arrière puis de la face avant. Ensuite, une fois ces dopages réalisés, on effectue un recuit commun d'activation.

Le tableau ci-dessous donne des résultats comparatifs de mesures de certains facteurs de performances entre un lot de cellules solaire muni d'une couche barrière et mises en œuvre à l'aide d'un procédé tel que décrit précédemment, et un lot de référence.

Les facteurs de performances évalués sont le PFF (« Pseudo Field-Factor »), la résistance parallèle Rshunt (dont la valeur est inverse est représentative de courants de fuite sur les bords) et la densité de courant de saturation J02 d'une diode lorsqu'on considère un circuit électrique équivalent à une cellule solaire muni d'une diode et d'une résistance de shunt.

| Moyenne (7 cellules) | PFF [%] | J02 [nA/cm²] | Rshunt [Ω] |
|---|---|---|---|
| Cellule avec couche barrière | 82.1 | 8.1 | 40933 |
| référence | 81.6 | 17.0 | 17573 |

## Revendications

1. Procédé de réalisation d'une cellule photovoltaïque comprenant de étapes de:
- formation sur des régions (2a) de bords latéraux (2) d'un substrat (1) à base de matériau semi-conducteur, d'une couche (4) barrière contenant au moins un dopant, la couche (4) barrière étant à base d'un matériau diélectrique, le dopant étant adapté pour réaliser un dopage d'un premier type, en particulier de type N, dudit matériau semi-conducteur, les bords latéraux (2) du substrat s'étendant entre une première face (AV) et une deuxième face (AR) du substrat opposée à la face première face,
- implantation de la première face (AV) du substrat (1) avec au moins une espèce dopante donnée adaptée pour réaliser un dopage d'un deuxième type, en particulier de type P, opposé au premier type de dopage, la couche barrière (4) étant configurée de manière à limiter une pénétration de ladite espèce dopante au niveau des bords latéraux du substrat,
- recuit thermique de sorte à réaliser une diffusion dans ledit matériau semi-conducteur du dopant contenu dans ladite couche (4) barrière au niveau des bords latéraux du substrat, de sorte à compenser ou surpasser le dopage réalisé lors de l'implantation de la première face (AV) du substrat (1).

2. Procédé selon la revendication 1, la couche (4) barrière étant formée de sorte à recouvrir des régions périphériques (3a) de la deuxième face (AR) du substrat (1).

3. Procédé selon la revendication 2, dans lequel la couche (4) barrière est formée par dépôt localisé tandis qu'un masquage est disposé sur la deuxième face (AR) du substrat, les régions périphériques (3a) de la deuxième face (AR) n'étant pas recouvertes par le masquage.

4. Procédé selon l'une des revendications 1 à 3, l'implantation de la première face (AV) du substrat (1) étant effectuée par immersion plasma.

5. Procédé selon l'une des revendications 1 à 4, dans lequel le recuit thermique est prévu selon une durée et une température adaptés de sorte à réaliser concomitamment une activation de ladite espèce dopante donnée implantée au niveau de la première face (AV) du substrat.

6. Procédé selon l'une des revendications 1 à 5, comprenant en outre des étapes de :
- dopage d'un premier type, en particulier de type N, au niveau la deuxième face (AR) du substrat, puis
- recuit de sorte à réaliser une activation de dopants, au niveau la deuxième face (AR) et une redistribution desdits dopants du premier type, en particulier de type N, au niveau des bords latéraux du substrat.

7. Procédé selon l'une des revendications 1 à 6, dans lequel le matériau semi-conducteur est dopé selon un dopage du premier type, en particulier de type N.

8. Procédé selon l'une des revendications 1 à 7, dans lequel l'espèce dopante donnée est du Bore, la couche (4) barrière étant dopée au Phosphore.

9. Procédé selon l'une des revendications 1 à 8, dans lequel la couche barrière (4) est une couche de nitrure de silicium dopée au phosphore ou d'oxyde de silicium dopée au Phosphore.

## Patentansprüche

1. Verfahren zum Herstellen einer photovoltaischen Zelle, das die folgenden Schritte umfasst:
- Bilden einer Sperrschicht (4), die mindestens einen Dotierstoff enthält, auf Bereichen (2a) von Seitenkanten (2) eines Substrats (1) auf Basis von Halbleitermaterial, wobei die Sperrschicht (4) auf Basis eines dielektrischen Materials besteht, wobei der Dotierstoff geeignet ist, eine Dotierung eines ersten Typs, insbesondere eine n-Dotierung, des Halbleitermaterials durchzuführen, wobei sich die Seitenkanten (2) des Substrats zwischen einer ersten Seite (AV) und einer der ersten Seite entgegengesetzten zweiten Seite (AR) des Substrats erstrecken,
- Implantation in die erste Seite (AV) des Substrats (1) von zumindest einer gegebenen Dotierstoffspezies, die geeignet ist, eine Dotierung eines zweiten Typs, insbesondere eine p-Dotierung, entgegengesetzt zum ersten Dotierungstyp durchzuführen, wobei die Sperrschicht (4) dazu ausgelegt ist, ein Eindringen der Dotierstoffspezies in den Bereich der Seitenkanten des Substrats zu begrenzen,
- thermisches Tempern, um eine Diffusion des in der Sperrschicht (4) enthaltenen Dotierstoffs in das Halbleitermaterial an den Seitenkanten des Substrats zu erreichen, so dass die bei der Implantation erhaltene Dotierung in der ersten Seite (AV) des Substrats (1) kompensiert oder überschritten wird.

2. Verfahren nach Anspruch 1, wobei die Sperrschicht (4) so gebildet wird, dass sie Umfangsbereiche (3a) der zweiten Seite (AR) des Substrats (1) bedeckt.

3. Verfahren nach Anspruch 2, wobei die Sperrschicht (4) durch lokalisierte Abscheidung gebildet wird, während eine Maskierung auf der zweiten Seite (AR) des Substrats angeordnet ist, wobei die Umfangsbereiche (3a) der zweiten Seite (AR) nicht von der Maskierung bedeckt sind.

4. Verfahren nach einem der Ansprüche 1 bis 3, wobei die Implantation in die erste Seite (AV) des Substrats (1) durch Plasmatauchen erfolgt.

5. Verfahren nach einem der Ansprüche 1 bis 4, wobei das thermische Tempern mit einer Zeit und Temperatur erfolgt, die so angepasst sind, dass zugleich eine Aktivierung der gegebenen Dotierstoffspezies durchgeführt wird, die im Bereich der ersten Seite (AV) des Substrats implantiert ist.

6. Verfahren nach einem der Ansprüche 1 bis 5, ferner umfassend die folgenden Schritte:
- Dotierung eines ersten Typs, insbesondere n-Dotierung, im Bereich der zweiten Seite (AR) des Substrats, dann
- Tempern, um eine Aktivierung der Dotierstoffe im Bereich der zweiten Seite (AR) und eine Umverteilung der Dotierstoffe des ersten Typs, insbesondere der n-Dotierung, im Bereich der Seitenkanten des Substrats zu bewirken.

7. Verfahren nach einem der Ansprüche 1 bis 6, wobei das Halbleitermaterial gemäß einer Dotierung des ersten Typs, insbesondere einer n-Dotierung, dotiert wird.

8. Verfahren nach einem der Ansprüche 1 bis 7, wobei die gegebene Dotierstoffspezies Bor ist und die Sperrschicht (4) mit Phosphor dotiert ist.

9. Verfahren nach einem der Ansprüche 1 bis 8, wobei die Sperrschicht (4) eine Schicht aus phosphordotiertem Siliziumnitrid oder aus phosphordotiertem Siliciumoxid ist.

## Claims

1. Method for producing a photovoltaic cell, comprising steps of:
- forming, on regions (2a) of lateral edges (2) of a substrate (1) having a semi-conductive material base, a barrier layer (4) containing at least one dopant, the barrier layer (4) having a dielectric material base, the dopant being adapted to produce a first type of doping, in particular N-type doping, of said semi-conductive material, the lateral edges (2) of the substrate extending between a first face (AV) and a second face (AR) of the substrate opposite the first face,
- implanting the first face (AV) of the substrate (1) with at least one given doping species adapted to produce a second type of doping, in particular P-type doping, opposite to the first type of doping, the barrier layer (4) being configured so as to limit penetration of said doping species to the lateral edges of the substrate,
- thermal annealing so as to produce a diffusion in said semi-conductive material of the dopant contained in said barrier layer (4) at the lateral edges of the substrate, so as to compensate or over-compensate the doping produced during the implantation of the first face (AV) of the substrate (1).

2. Method according to claim 1, wherein the barrier layer (4) is formed so as to cover peripheral regions (3a) of the second face (AR) of the substrate (1).

3. Method according to claim 2, wherein the barrier layer (4) is formed by localised deposition, whereas a masking is disposed on the second face (AR) of the substrate, the peripheral regions (3a) of the second face (AR) not being covered by the masking.

4. Method according to one of claims 1 to 3, wherein the implantation of the first face (AV) of the substrate (1) is carried out by plasma immersion.

5. Method according to one of claims 1 to 4, wherein the thermal annealing is carried out with a duration and at a temperature that are adapted so as to concomitantly activate said given doping species implanted at the first face (AV) of the substrate.

6. Method according to one of claims 1 to 5, further comprising steps of:
- carrying out a first type of doping, in particular N-type doping, at the second face (AR) of the substrate, then
- annealing so as to activate the dopants, at the second face (AR), and redistribute said dopants of the first type, in particular the N-type dopants, at the lateral edges of the substrate.

7. Method according to one of claims 1 to 6, wherein the semi-conductive material is doped by a first type of doping, in particular N-type doping.

8. Method according to one of claims 1 to 7, wherein the given doping species is Boron, the barrier layer (4) being doped with Phosphorus.

9. Method according to one of claims 1 to 8, wherein the barrier layer (4) is a phosphorus-doped silicon nitride layer or a phosphorus-doped silicon oxide layer.
